# EUROPÄISCHE PATENTSCHRIFT

(11) **EP 2 653 019 B1**
(45) Veröffentlichungstag und Bekanntmachung des Hinweises auf die Patenterteilung: **26.04.2017**
(21) Anmeldenummer: 11784968.7
(22) Anmeldetag: 03.11.2011
(51) Int. Cl.: H05K 7/14, H05K 5/00

(54) **STEUERGERÄT UND VERFAHREN ZUM HERSTELLEN EINES STEUERGERÄTS**
CONTROL DEVICE AND METHOD FOR PRODUCING A CONTROL DEVICE
APPAREIL DE COMMANDE ET PROCÉDÉ DE FABRICATION D'UN APPAREIL DE COMMANDE

(30) Priorität: 15.12.2010 DE 102010063151
(43) Veröffentlichungstag der Anmeldung: 23.10.2013
(73) Patentinhaber: Robert Bosch GmbH, 70442 Stuttgart (DE)
(72) Erfinder: KOEHN, Dietrich, 71634 Ludwigsburg (DE); HENNEL, Udo, 74343 Sachsenheim (DE)
(86) Internationale Anmeldenummer: PCT/EP2011/069339
(87) Internationale Veröffentlichungsnummer: WO 2012/079837

(56) Entgegenhaltungen:
- WO-A1-01/87029
- DE-A1-102005 022 402
- DE-A1-102005 030 381
- DE-A1-102008 000 442
- JP-A- 2005 217 075

## Beschreibung

### Stand der Technik

Die Erfindung betrifft ein Steuergerät nach dem Oberbegriff der beiden unabhängigen Ansprüche 1 und 3. Ferner betrifft die Erfindung ein Verfahren zum Herstellen eines Steuergeräts.

Ein Steuergerät nach dem Oberbegriff der unabhängigen Ansprüche ist aus der DE 10 2005 022 402 A1 der Anmelderin bekannt. Bei dem bekannten Steuergerät wird eine Leiterplatte unter Zwischenlage eines an einer Seite der Leiterplatte angeordneten elastischen Dämpfungselements zwischen einem Bodenteil und einem Deckelteil des Steuergerätegehäuses verklemmt. Bei dem in der Schrift gezeigten Ausführungsbeispiel befindet sich das elastische Dämpfungsmedium dabei in einem Randbereich des Steuergeräts. Um die benötigte elastische Lagerung der Leiterplatte sowie die sichere Anbindung der Leiterplatte an die Gehäuseteile sicherzustellen sind dabei relativ große Flächen mit dem Dämpfungsmedium zu versehen. Eine derartige Anordnung ist zwar üblicherweise bei Randbereichen der Leiterplatte unkritisch, doch in Zwischenbereichen, in denen üblicherweise elektronische Bauteile vorgesehen sind, oftmals schwierig zu realisieren.

Darüber hinaus sind aus der DE 10 2005 030 381 A1 und der DE 10 2008 000 442 A1 Steuergeräte bekannt, bei denen die Leiterplatte an domartigen Fortsätzen des Gehäuses mittels Schrauben und unter Zwischenlage eines Dämpfungselements in Form eines O-Rings befestigt ist. Es sind somit zusätzliche Befestigungselemente in Form der Schrauben erforderlich, um die Leiterplatte zu fixieren.

### Offenbarung der Erfindung

Ausgehend von dem dargestellten Stand der Technik liegt der Erfindung die Aufgabe zugrunde, ein Steuergerät nach dem Oberbegriff der unabhängigen Ansprüche derart weiterzubilden, dass eine verbesserte vibrationsgeschützte Anordnung und besonders sichere Befestigung der Leiterplatte in dem Gehäuse des Steuergeräts ermöglicht wird. Diese Aufgabe wird erfindungsgemäß bei einem Steuergerät mit den Merkmalen der Ansprüche 1 und 3 gelöst. Der Grundgedanke der Erfindung besteht dabei darin, durch eine entsprechende Strukturierung der Kontaktflächen an dem Gehäuse bzw. durch das Vorsehen von Durchgangsöffnungen in der Leiterplatte ein gegenüber dem Stand der Technik, bezogen auf eine bestimmte Fläche der Leiterplatte, vergrößertes Volumen für das Dämpfungsmedium bereitzustellen. Dadurch wird insbesondere eine besonders gute Verbindung zwischen der Leiterplatte und den Gehäuseteilen erzielt.

Vorteilhafte Weiterbildungen der erfindungsgemäßen Anordnung einer Leiterplatte in einem Gehäuse eines Steuergeräts sind in den Unteransprüchen angegeben.

Besonders bevorzugt ist es, wenn beide Gehäuseteile Klemmabschnitte aufweisen, die zueinander fluchtend angeordnet sind. Dadurch wird insbesondere die Anordnung von elektrischen bzw. elektronischen Bauteilen auf beiden Seiten der Leiterplatte ermöglicht.

Weiterhin kann es vorgesehen sein, dass die Leiterplatte zu den Gehäuseteilen randseitig beabstandet angeordnet ist. Dadurch wird eine vollständig schwimmende Lagerung der Leiterplatte in dem Gehäuse ermöglicht, bei der über das Gehäuse keine Vibrationen direkt an die Leiterplatte übertragen werden.

Die Erfindung umfasst auch ein Verfahren zum Herstellen eines erfindungsgemäßen Steuergeräts. Hierbei ist es vorgesehen, dass in einem ersten Schritt ein Dämpfungsmedium auf wenigstens den Klemmabschnitten eines Gehäuseteils bzw. auf wenigstens einer Seite der Halteabschnitte der Leiterplatte aufgebracht wird, dass in einem zweiten Schritt die Leiterplatte mit den Klemmabschnitten in Wirkverbindung gebracht wird, dass in einem dritten Schritt das andere Gehäuseteil, vorzugsweise unter Zwischenlage weiteren Dämpfungsmediums, mit den Halteabschnitten der Leiterplatte in Wirkverbindung gebracht wird, so dass das Dämpfungsmedium zwischen den Klemmabschnitten und den Halteabschnitten der Leiterplatte verteilt wird. Ein derartiges Verfahren ermöglicht eine rationale Herstellung von Steuergeräten ohne zusätzlich erforderliche Montagewerkzeuge zum Verbinden der Leiterplatte mit den Gehäuseteilen. Vielmehr wird mittels des erfindungsgemäßen Verfahrens durch das Zusammenfügen der Gehäuseteile in gewünschter Weise gleichzeitig die elastische und feste Befestigung der Leiterplatte in den Gehäuseteilen realisiert.

Besonders bevorzugt ist es vorgesehen, wenn das Dämpfungsmedium auf beiden Seiten der Leiterplatte zumindest mittelbar aufgebracht wird. Dadurch wird eine Dämpfungswirkung in beide Richtungen der Leiterplatte erzielt.

Beim Vorhandensein von Durchgangsöffnungen auf der Leiterplatte ist es auch denkbar, dass das Dämpfungsmedium lediglich auf den Klemmabschnitten eines der beiden Gehäuseteile aufgebracht wird. Dadurch werden ein einfaches Handling der Leiterplatte sowie eine besonders kostengünstige Fertigung ermöglicht.

Weitere Vorteile, Merkmale und Einzelheiten der Erfindung ergeben sich aus der nachfolgenden Beschreibung bevorzugter Ausführungsbeispiele sowie anhand der Zeichnung. Diese zeigt in:
- Fig. 1: einen stark vereinfachten Querschnitt durch ein Steuergerät, bei dem eine Leiterplatte unter Verwendung eines Dämpfungsmediums zwischen den Gehäuseteilen befestigt ist,
- Fig. 2-6: Darstellungen zur Erläuterung des Fertigungsprozesses bei der Fixierung der Leiterplatte in dem Gehäuse des Steuergeräts zu unterschiedlichen Phasen und
- Fig. 7a - 7d: unterschiedlich gestaltete Klemmflächen an den Gehäuseteilen, jeweils in vereinfachten Längsschnitten.

Gleiche Bauteile bzw. Bauteile mit gleicher Funktion sind in den Figuren mit den gleichen Bezugsziffern versehen.

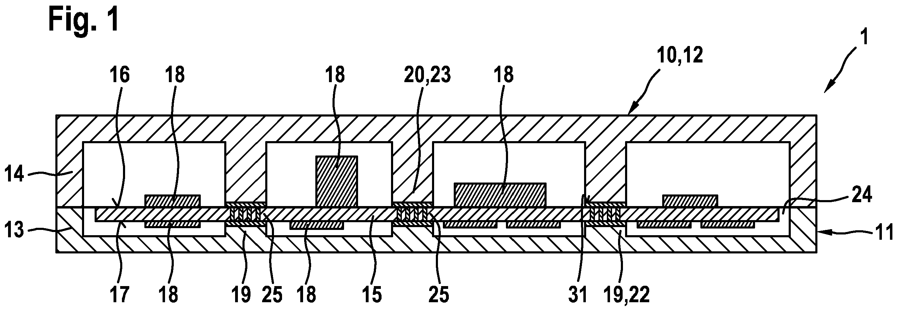

In der Fig. 1 ist stark vereinfacht ein Schnitt durch ein Gehäuse 10 eines erfindungsgemäßen Steuergeräts 1 dargestellt, wie es insbesondere in einem Kraftfahrzeug eingesetzt wird und mittel- oder unmittelbar an einer Karosserie des Kraftfahrzeugs befestigt ist.

Das Steuergerät 1 bzw. dessen Gehäuse 10 weist im Ausführungsbeispiel zwei Gehäuseteile 11, 12 auf, wobei das eine Gehäuseteil 11 als Bodenteil ausgebildet ist, während das andere, haubenförmige Gehäuseteil 12 ein Deckelteil bildet. Die beiden Gehäuseteile 11, 12 weisen jeweils an ihrem Umfang einen umlaufenden Randbereich 13, 14 auf, die bei miteinander verbundenen Gehäuseteilen 11, 12 an ihren zugewandten Stirnseiten bzw. Stirnflächen dicht aneinander liegen. Hierbei kann es vorgesehen sein, dass zwischen den beiden Randbereichen 13, 14 eine nicht dargestellte Dichtung angeordnet ist, um das Gehäuse 10 vor dem Eindringen von Feuchtigkeit, Schmutz oder ähnlichem zu schützen. Die beiden Gehäuseteile 11, 12 des Gehäuses 10 sind auf an sich bekannte Art und Weise miteinander verbunden, z.B. durch Schraubverbindungen, Bördelverbindungen, Klebeverbindungen oder ähnlichem.

Innerhalb des Gehäuses 10 des Steuergeräts 1 ist ein Schaltungsträger in Form einer Leiterplatte 15 angeordnet. Die Leiterplatte 15 ist über eine in der Fig. 1 nicht dargestellte Steckerleiste elektrisch kontaktiert, die über die Gehäuseaußenseite mit einem Gegenstecker, insbesondere mit einem Gegenstecker des Kabelbaums des Kraftfahrzeugs, elektrisch verbunden ist. Auf der Leiterplatte 15 sind sowohl auf deren Oberseite 16, als auch auf deren Unterseite 17 elektrisch oder elektronische Bauelemente 18 angeordnet.

Erfindungswesentlich ist die Anordnung bzw. Befestigung der Leiterplatte 15 innerhalb des Gehäuses 10. Hierzu ist es vorgesehen, dass sowohl das Gehäuseteil 11, als auch das Gehäuseteil 12 jeweils in Richtung der Leiterplatte 15 ragende Auflagepunkte in Form von Erhebungen 19, 20 aufweist, die als Klemmabschnitte 22, 23 für die Leiterplatte 15 wirken. Wesentlich ist weiterhin, dass die Klemmabschnitte 22, 23, wie anhand der Fig. 1 besonders deutlich erkennbar ist, fluchtend zueinander angeordnet sind, derart, dass sie mit der Oberseite 16 bzw. die Unterseite 17 der Leiterplatte 15 zusammenwirken. Im Ausführungsbeispiel sind jeweils drei Erhebungen 19, 20 dargestellt. Diese können bezüglich ihres Querschnitts grundsätzlich beliebig, vorzugsweise jedoch rund oder rechteckförmig ausgebildet sein. Ferner können diese über Teilbereiche der Leiterplatte 15 oder aber über die gesamte Länge bzw. Breite der Leiterplatte 15 angeordnet sein. Ferner erkennt man, dass die Leiterplatte 15 randseitig mit einem Spalt 24 zu den Gehäuseteilen 11, 12 angeordnet ist. Weiterhin bildet die Leiterplatte 15 im Bereich der Erhebungen 19, 20 Halteabschnitte 25 aus, die in Überdeckung mit den Erhebungen 19, 20 bzw. den Klemmabschnitten 22, 23 angeordnet sind.

Bevorzugt ist es vorgesehen, dass in den Halteabschnitten 25 der Leiterplatte 15 Durchgangsbohrungen bzw. Durchgangsöffnungen 26 ausgebildet sind. Bei dem in den Fig. 1 bis 6 dargestelltem Ausführungsbeispiel weist hierbei jeder Halteabschnitt 25 vier parallel zueinander angeordnete Durchgangsöffnungen 26, z.B. in Form von Bohrungen, auf. Erfindungsgemäß ist es vorgesehen, dass zwischen der Leiterplatte 15 und den Gehäuseteilen 11, 12 im Bereich der Klemmabschnitte 22, 23 ein Dämpfungsmedium 30 angeordnet ist.

Das Dämpfungsmedium 30 weist während der Montage des Steuergeräts 1 eine viskose Eigenschaft auf, das heißt, es ist als flüssiges oder pastöses Dämpfungsmedium 30, insbesondere als gummiartiges Dämpfungsmedium 30, ausgebildet. Nach einer bestimmten Zeit bzw. bei bestimmten Umgebungsbedingungen, z.B. bei Wärme oder UV-Strahlung, härtet das Dämpfungsmedium 30 aus, wobei es jedoch weiterhin elastische bzw. dämpfende Eigenschaften aufweist.

In den Fig. 1 bis 6 sind die Klemmabschnitte 22, 23 der Erhebungen 19, 20 in Form von ebenen Kontaktflächen 31 für das Dämpfungsmedium 30 ausgebildet. Die Kontaktflächen 31 können, wie später noch beschrieben, jedoch auch eine andere Form bzw. Struktur aufweisen.

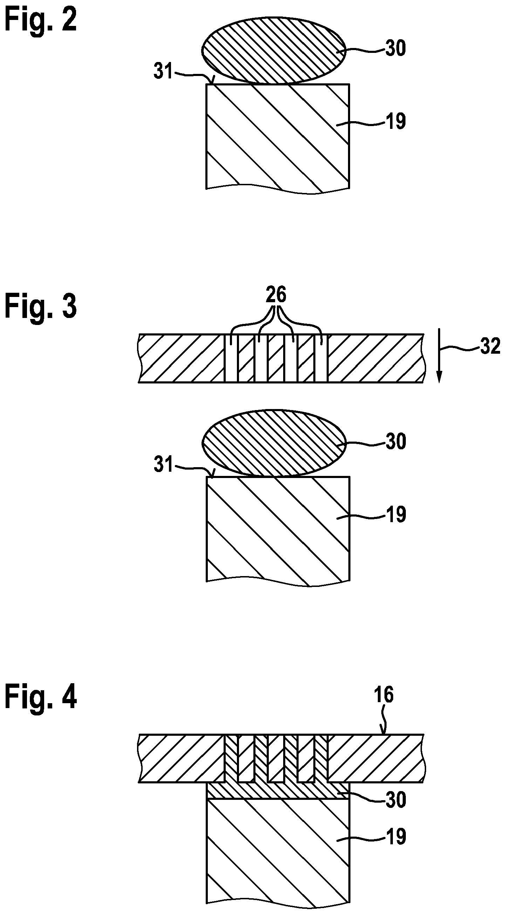

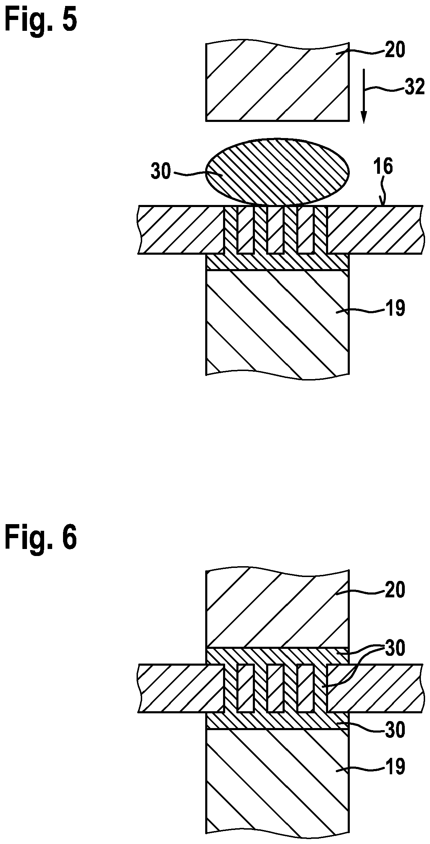

Der Montagevorgang eines Steuergeräts 1 wird nunmehr anhand der Fig. 2 bis 6 näher erläutert, wobei der Einfachheit halber dies anhand des Bereichs einer Erhebung 19, 20 beschrieben wird. Die nachfolgenden Fertigungsschritte werden jedoch selbstverständlich sinngemäß an allen Erhebungen 19, 20 ausgeführt: Man erkennt anhand der Fig. 2, dass in einem ersten Fertigungsschritt auf die Kontaktfläche 31 der Erhebung 19 des Klemmabschnitts 22 eine bestimmte Menge an Dämpfungsmedium 30 mittels einer nicht dargestellten Dosiereinrichtung aufgebracht wird. Anschließend wird entsprechend der Fig. 3 die Leiterplatte 15 mit ihrem Halteabschnitt 25 entsprechend der Richtung des Pfeils 32 in Richtung der Erhebung 19 bewegt. Entsprechend der Fig. 4 wird die Leiterplatte 15 soweit in Richtung der Erhebung 19 bewegt, bis eine gewisse Menge des Dämpfungsmediums 30 zumindest teilweise, im Ausführungsbeispiel vollständig, in die Durchgangsöffnung 26 gelangt. Anschließend wird entsprechend der Fig. 5 eine zweite Menge vom Dämpfungsmedium 30 auf die Oberseite 16 der Leiterplatte 15 im Bereich der Durchgangsöffnungen 26 aufgebracht. Danach wird die Erhebung 20 des Klemmabschnitts 23 in Richtung des Pfeils 33 gegen die Leiterplatte 15 bewegt, bis entsprechend der Fig. 6 das auf der Oberseite 16 der Leiterplatte 15 befindliche Dämpfungsmedium 30 sich zumindest über dem Bereich der Erhebung 20 verteilt hat und in Kontakt mit dem zuvor aufgebrachten Dämpfungsmedium 30 auf der Unterseite 17 der Leiterplatte 15 gelangt.

In diesem Zustand sowie gegebenenfalls weiteren Montageschritten hinsichtlich der elektrischen Kontaktierung der Leiterplatte 15 werden die beiden in den Fig. 2 bis 6 nicht dargestellten Gehäuseteile 11, 12 auf die zuvor bereits beschriebene Art und Weise miteinander verbunden, wodurch der Montageprozess des Steuergeräts 1 abgeschlossen ist.

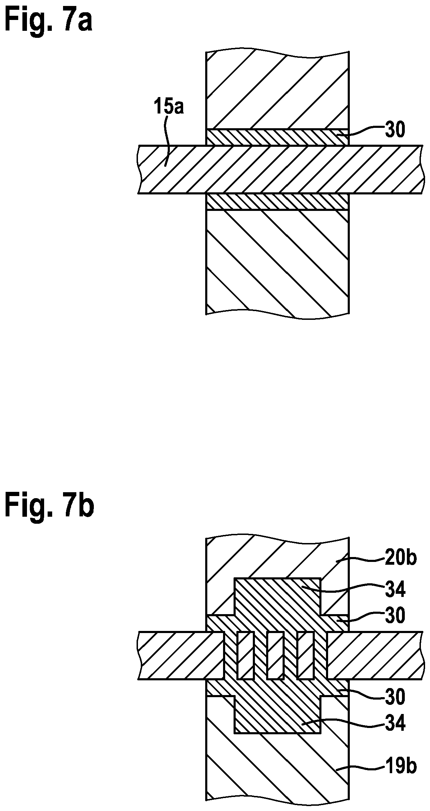

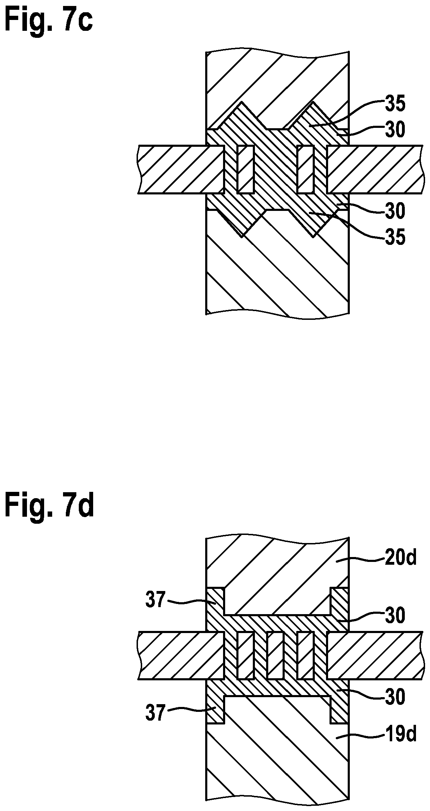

In den Fig. 7a - 7d sind weitere Ausgestaltungen der Erfindung dargestellt. In der Fig. 7a ist erkennbar, dass die Leiterplatte 15a im Gegensatz zur Leiterplatte 15 keine Durchgangsöffnungen 26 aufweist. In der Fig. 7b ist der Fall dargestellt, bei der die Erhebungen 19b, 20b jeweils eine Vertiefung 34, z.B. in Form einer Sacklochbohrung, aufweist. In der Fig. 7c ist der Fall dargestellt, bei der die Vertiefungen 35 in Form von im Querschnitt dreiecksförmigen Vertiefungen 35 ausgebildet sind. Zuletzt zeigt die Fig. 7d den Fall, bei der die Erhebungen 19d, 20d eine umlaufende Absenkung 37 aufweisen. Bei dem in den Figuren 7b bis 7d dargestellten Ausführungsbeispielen wird gegenüber der Fig. 7a eine größere Menge von Dämpfungsmedium 30 im Bereich der Erhebungen gespeichert. Weiterhin wird durch die Ausgestaltung der Erhebungen ein Formschluss zwischen dem Dämpfungsmedium 30 und den Erhebungen erzielt, was ein besonders sicheres Halten der Leiterplatte 15 zur Folge hat.

Das soweit beschriebene Steuergerät 10 kann in vielfältiger Art und Weise abgewandelt bzw. modifiziert werden, ohne vom Erfindungsgedanken abzuweichen. Dieser besteht in einer schwimmenden Lagerung der Leiterplatte 15 mittels eines Dämpfungsmediums 30, das zunächst als viskoses Dämpfungsmedium 30 ausgebildet ist, und anschließend unter Beibehaltung elastischer Eigenschaften aushärtet. So ist es beispielweise denkbar, insbesondere beim Vorhandensein von Durchgangsöffnungen 26, das Dämpfungsmedium 30 lediglich auf einer Seite der Leiterplatte 15 anzuordnen, so dass das Dämpfungsmedium 30 beim Zusammenfügen der beiden Gehäuseteile 11, 12 durch die Durchgangsöffnungen gequetscht wird und auf die andere Seite der Leiterplatte 15 gelangt. Ggf. sind auch Lösungen denkbar, bei denen das Dämpfungsmedium 30 sich lediglich auf einer Seite der Leiterplatte 15 befindet, und von der anderen Seite mit einem festen bzw. starren Element in Richtung des Dämpfungsmediums 30 gedrückt wird.

## Patentansprüche

1. Steuergerät (1), mit einer innerhalb eines Gehäuses (10) angeordneten Leiterplatte (15; 15a), wobei das Gehäuse (10) aus wenigstens zwei Gehäuseteilen (11, 12) besteht, die miteinander verbunden sind, und mit Halteabschnitten (25) der Leiterplatte (15; 15a), die mit Klemmabschnitten (22, 23) der Gehäuseteile (11, 12) zusammenwirken, wobei zwischen den Halteabschnitten (25) der Leiterplatte (15, 15a) und den damit zusammenwirkenden Klemmabschnitten (22, 23) der Gehäuseteile (11, 12) wenigstens auf einer Seite der Leiterplatte (15, 15a) ein elastisches Dämpfungsmedium angeordnet ist, das die Leiterplatte (15, 15a) in dem Gehäuse (10) fixiert, wobei die Klemmabschnitte (22, 23) der Gehäuseteile (11, 12) ausschließlich innerhalb der Gehäuseteile (11, 12) angeordnet sind, wobei wenigstens eines der Gehäuseteile (12) haubenförmig ausgebildet ist und einen umlaufenden Randbereich (14) aufweist, der mit dem anderen Gehäuseteil (12), gegebenenfalls unter Zwischenlage einer Dichtung, zusammenwirkt, und wobei die Klemmabschnitte (22, 23) der Gehäuseteile (11, 12) als Erhebungen (19; 19b; 19d, 20; 20b; 20d) ausgebildet sind, wobei das Dämpfungsmedium (30) ein im Montagezustand viskoses und nach der Aushärtung elastisches Dämpfungsmedium (30) ist, **dadurch gekennzeichnet, dass** die Klemmabschnitte (22 ,12) auf der der Leiterplatte (15; 15a) zugewandten Seite eine zumindest annähernd ebene Kontaktfläche (31) oder eine strukturierte Kontaktfläche in Form wenigstens einer Vertiefung (34, 35) oder einer Umfangsnut (37) zur Aufnahme einer gegenüber einer ebenen Kontaktfläche (31) vergrößerten Menge an Dämpfungsmedium (30) aufweisen.

2. Steuergerät nach Anspruch 1,
**dadurch gekennzeichnet,**
**dass** die Leiterplatte (15) im Bereich der Halteabschnitte (25) wenigstens eine Durchgangsöffnung (26) für das Dämpfungsmedium (30) aufweist.

3. Steuergerät (1), mit einer innerhalb eines Gehäuses (10) angeordneten Leiterplatte (15; 15a), wobei das Gehäuse (10) aus wenigstens zwei Gehäuseteilen (11, 12) besteht, die miteinander verbunden sind, und mit Halteabschnitten (25) der Leiterplatte (15; 15a), die mit Klemmabschnitten (22, 23) der Gehäuseteile (11, 12) zusammenwirken, wobei zwischen den Halteabschnitten (25) der Leiterplatte (15, 15a) und den damit zusammenwirkenden Klemmabschnitten (22, 23) der Gehäuseteile (11, 12) wenigstens auf einer Seite der Leiterplatte (15, 15a) ein elastisches Dämpfungsmedium angeordnet ist, das die Leiterplatte (15, 15a) in dem Gehäuse (10) fixiert, wobei die Klemmabschnitte (22, 23) der Gehäuseteile (11, 12) ausschließlich innerhalb der Gehäuseteile (11, 12) angeordnet sind, wobei wenigstens eines der Gehäuseteile (12) haubenförmig ausgebildet ist und einen umlaufenden Randbereich (14) aufweist, der mit dem anderen Gehäuseteil (12), gegebenenfalls unter Zwischenlage einer Dichtung, zusammenwirkt, und wobei die Klemmabschnitte (22, 23) der Gehäuseteile (11, 12) als Erhebungen (19; 19b; 19d, 20; 20b; 20d) ausgebildet sind,
wobei
das Dämpfungsmedium (30) ein im Montagezustand viskoses und nach der Aushärtung elastisches Dämpfungsmedium (30) ist, **dadurch gekennzeichnet, dass** die Leiterplatte (15) im Bereich der Halteabschnitte (25) wenigstens eine Durchgangsöffnung (26) für das Dämpfungsmedium (30) aufweist.

4. Steuergerät nach Anspruch 3,
**dadurch gekennzeichnet,**
**dass** die Klemmabschnitte (22, 23) auf der der Leiterplatte (15; 15a) zugewandten Seite eine zumindest annähernd ebene Kontaktfläche (31) oder eine strukturierte Kontaktfläche in Form wenigstens einer Vertiefung (34, 35) oder einer Umfangsnut (37) zur Aufnahme einer gegenüber einer ebenen Kontaktfläche (31) vergrößerten Menge an Dämpfungsmedium (30) aufweisen.

5. Steuergerät nach Anspruch 1 bis 4,
**dadurch gekennzeichnet,**
**dass** beide Gehäuseteile (11, 12) Klemmabschnitte (22, 23) aufweisen, die zueinander fluchtend angeordnet sind.

6. Steuergerät nach einem der Ansprüche 1 bis 5,
**dadurch gekennzeichnet,**
**dass** die Leiterplatte (15; 15a) zu den Gehäuseteilen (11, 12) randseitig über einen Spalt (24) beabstandet angeordnet ist.

7. Verfahren zum Herstellen eines Steuergeräts (1) nach einem der Ansprüche 1 bis 6,
**dadurch gekennzeichnet,**
**dass** in einem ersten Schritt ein Dämpfungsmedium (30) auf wenigstens den Klemmabschnitten (22) eines Gehäuseteils (11) bzw. auf wenigstens einer Seite der Halteabschnitte (25) der Leiterplatte (15; 15a) aufgebracht wird, dass in einem zweiten Schritt die Leiterplatte (15; 15a) mit den Klemmabschnitten (22) in Wirkverbindung gebracht wird, dass in einem dritten Schritt das andere Gehäuseteil (12), vorzugsweise unter Zwischenlage weiteren Dämpfungsmediums (30), mit den Halteabschnitten (25) der Leiterplatte (15; 15a) in Wirkverbindung gebracht wird, so dass das Dämpfungsmedium (30) zwischen den Klemmabschnitten (22, 23) und den Halteabschnitten (25) der Leiterplatte (15; 15a) verteilt wird.

8. Verfahren nach Anspruch 7,
**dadurch gekennzeichnet,**
**dass** das Dämpfungsmedium (30) auf beiden Seiten der Leiterplatte (15; 15a) zumindest mittelbar aufgebracht wird.

9. Verfahren nach Anspruch 8,
**dadurch gekennzeichnet,**
**dass** das Dämpfungsmedium (30) lediglich auf den Klemmabschnitten (22, 23) eines der beiden Gehäuseteile (11, 12) aufgebracht wird, insbesondere, wenn die Leiterplatte (15) Durchgangsöffnungen (26) aufweist.

## Claims

1. Control device (1), comprising a printed circuit board (15; 15a) which is arranged within a housing (10), wherein the housing (10) comprises at least two housing parts (11, 12) which are connected to one another, and comprising holding sections (25) of the printed circuit board (15; 15a) which interact with clamping sections (22, 23) of the housing parts (11, 12), wherein an elastic damping medium, which fixes the printed circuit board (15, 15a) in the housing (10), is arranged between the holding sections (25) of the printed circuit board (15, 15a) and the clamping sections (22, 23), which interact with the said holding sections, of the housing parts (11, 12) at least on one side of the printed circuit board (15, 15a), wherein the clamping sections (22, 23) of the housing parts (11, 12) are arranged solely within the housing parts (11, 12), wherein at least one of the housing parts (12) is of hood-like design and has a circumferential edge region (14) which interacts with the other housing part (12), possibly with the interposition of a seal, and wherein the clamping sections (22, 23) of the housing parts (11, 12) are in the form of raised portions (19; 19b; 19d, 20; 20b; 20d), wherein the damping medium (30) is a damping medium (30) which is viscous in the mounting state and elastic after curing, **characterized in that** the clamping sections (22, 12) on the side which faces the printed circuit board (15; 15a) have an at least approximately planar contact area (31) or a structured contact area in the form of at least one recess (34, 35) or a circumferential groove (37) for receiving an increased quantity of damping medium (30) in comparison to a planar contact area (31).

2. Control device according to Claim 1, **characterized in that** the printed circuit board (15) has at least one passage opening (26) for the damping medium (30) in the region of the holding sections (25).

3. Control device (1), comprising a printed circuit board (15; 15a) which is arranged within a housing (10), wherein the housing (10) comprises at least two housing parts (11, 12) which are connected to one another, and comprising holding sections (25) of the printed circuit board (15; 15a) which interact with clamping sections (22, 23) of the housing parts (11, 12), wherein an elastic damping medium, which fixes the printed circuit board (15, 15a) in the housing (10), is arranged between the holding sections (25) of the printed circuit board (15, 15a) and the clamping sections (22, 23), which interact with said holding sections, of the housing parts (11, 12) at least on one side of the printed circuit board (15, 15a), wherein the clamping sections (22, 23) of the housing parts (11, 12) are arranged solely within the housing parts (11, 12), wherein at least one of the housing parts (12) is of hood-like design and has a circumferential edge region (14) which interacts with the other housing part (12), possibly with the interposition of a seal, and wherein the clamping sections (22, 23) of the housing parts (11, 12) are in the form of raised portions (19; 19b; 19d, 20; 20b; 20d), wherein the damping medium (30) is a damping medium (30) which is viscous in the mounting state and elastic after curing, **characterized in that** the printed circuit board (15) has at least one passage opening (26) for the damping medium (30) in the region of the holding sections (25).

4. Control device according to Claim 3, **characterized in that** the clamping sections (22, 23) on the side which faces the printed circuit board (15; 15a) have an at least approximately planar contact area (31) or a structured contact area in the form of at least one recess (34, 35) or a circumferential groove (37) for receiving an increased quantity of damping medium (30) in comparison to a planar contact area (31).

5. Control device according to Claims 1 to 4, **characterized in that** the two housing parts (11, 12) have clamping sections (22, 23) which are arranged in alignment with one another.

6. Control device according to one of Claims 1 to 5, **characterized in that** the printed circuit board (15; 15a) is arranged at a distance from the housing parts (11, 12) by means of a gap (24) at the edge.

7. Method for producing a control device (1) according to one of Claims 1 to 6, **characterized in that**, in a first step, a damping medium (30) is applied to at least the clamping sections (22) of a housing part (11) or to at least one side of the holding sections (25) of the printed circuit board (15; 15a), **in that**, in a second step, the printed circuit board (15; 15a) is operatively connected to the clamping sections (22), **in that**, in a third step, the other housing part (12) is operatively connected to the holding sections (25) of the printed circuit board (15; 15a), preferably with the interposition of further damping medium (30), so that the damping medium (30) is distributed between the clamping sections (22, 23) and the holding sections (25) of the printed circuit board (15; 15a).

8. Method according to Claim 7, **characterized in that** the damping medium (30) is at least indirectly applied to both sides of the printed circuit board (15; 15a).

9. Method according to Claim 8, **characterized in that** the damping medium (30) is applied only to the clamping sections (22, 23) of one of the two housing parts (11, 12), in particular when the printed circuit board (15) has passage openings (26).

## Revendications

1. Appareil de commande (1), comportant une carte de circuit imprimé (15 ; 15a) disposée dans un boîtier (10), dans lequel le boîtier (10) est constitué d'au moins deux parties de boîtier (11, 12) qui sont reliées l'une à l'autre, et comportant des parties de retenue (25) de la carte de circuit imprimé (15 ; 15a), qui coopèrent avec des parties de serrage (22, 23) des parties de boîtier (11, 12), dans lequel il est prévu entre les parties de retenue (25) de la carte de circuit imprimé (15 ; 15a) et les parties de serrage (22, 23) coopérant avec celles-ci des parties de boîtier (11, 12), au moins un milieu amortisseur élastique d'un côté de la carte de circuit imprimé (15, 15a) qui fixe la carte de circuit imprimé (15, 15a) dans le boîtier (10), dans lequel les parties de serrage (22, 23) des parties de boîtier (11, 12) sont exclusivement disposées à l'intérieur des parties de boîtier (11, 12), dans lequel au moins l'une des parties de boîtier (12) est réalisée sous forme de capot et présente une zone de bord (14) circonférentielle qui coopère avec l'autre partie de boîtier (12), le cas échéant avec interposition d'un élément d'étanchéité, et dans lequel les parties de serrage (22, 23) des parties de boîtier (11, 12) sont réalisées sous la forme de protubérances (19 ; 19b ; 19d, 20 ; 20b ; 20d),
dans lequel le milieu amortisseur (30) est un milieu amortisseur (30) visqueux à l'état de montage et élastique après durcissement, **caractérisé en ce que** les parties de serrage (22, 12), du côté qui est opposé à la carte de circuit imprimé (15 ; 15a), présentent une surface de contact (31) au moins sensiblement plane ou une surface de contact structurée sous la forme d'au moins un évidement (34, 35) ou d'une rainure circonférentielle (37) destinée à recevoir une quantité supérieure de milieu amortisseur (30) par rapport à une surface de contact plane (31).

2. Appareil de commande selon la revendication 1, **caractérisé en ce que** la carte de circuit imprimé (15) présente, dans la région des parties de retenue (25), au moins une ouverture de passage (26) destinée au milieu amortisseur (30).

3. Appareil de commande (1), comportant une carte de circuit imprimé (15 ; 15a) disposée à l'intérieur d'un boîtier (10), dans lequel le boîtier (10) est constitué d'au moins deux parties de boîtier (11, 12) qui sont reliées l'une à l'autre, et comportant des parties de retenue (25) de la carte de circuit imprimé (15 ; 15a), qui coopèrent avec des parties de serrage (22, 23) des parties de boîtier (11, 12), dans lequel il est prévu entre les parties de retenue (25) de la carte de circuit imprimé (15 ; 15a) et les parties de serrage (22, 23) des parties de boîtier (11, 12) qui coopèrent avec celles-ci, un milieu amortisseur élastique au moins d'un côté de la carte de circuit imprimé (15, 15a), lequel milieu amortisseur fixe la carte de circuit imprimé (15, 15a) dans le boîtier (10), dans lequel les parties de serrage (22, 23) des parties de boîtier (11, 12) sont exclusivement disposées à l'intérieur des parties de boîtier (11, 12), dans lequel au moins l'une des parties de boîtier (12) est réalisée sous forme de capot et présente une zone de bord (14) circonférentielle qui coopère avec l'autre partie de boîtier (12), le cas échéant avec interposition d'un élément d'étanchéité, et dans lequel les parties de serrage (22, 23) des parties de boîtier (11, 12) sont réalisées sous la forme de protubérances (19 ; 19b ; 19d, 20 ; 20b ; 20d),
dans lequel le milieu amortisseur (30) est un milieu amortisseur (30) visqueux à l'état de montage et élastique après durcissement, **caractérisé en ce que** la carte de circuit imprimé (15) présente dans la région de la partie de retenue (25) au moins une ouverture de passage (26) destinée au milieu amortisseur (30).

4. Appareil de commande selon la revendication 3, **caractérisé en ce que** les parties de serrage (22, 23) présentent, du côté opposé à la carte de circuit imprimé (15 ; 15a), une surface de contact (31) au moins approximativement plane ou une surface de contact structurée sous la forme d'au moins un évidement (34, 35) ou d'une rainure circonférentielle (37) destinée à recevoir une quantité supérieure de milieu amortisseur (30) par rapport à une surface de contact plane (31).

5. Appareil de commande selon l'une quelconque des revendications 1 à 4,
**caractérisé en ce que** les deux parties de boîtier (11, 12) présentent des parties de serrage (22, 23) qui sont disposées de manière à affleurer l'une par rapport à l'autre.

6. Appareil de commande selon l'une quelconque des revendications 1 à 5,
**caractérisé en ce que** la carte de circuit imprimé (15 ; 15a) est disposée espacée du côté des bords d'un interstice (24) par rapport aux parties de boîtier (11, 12).

7. Procédé de fabrication d'un appareil de commande (1) selon l'une quelconque des revendications 1 à 6,
**caractérisé en ce que**, lors d'une première étape, un milieu amortisseur (30) est déposé sur au moins les parties de serrage (22) d'une partie de boîtier (11) ou sur au moins une face des parties de retenue (25) de la carte de circuit imprimé (15 ; 15a), **en ce que**, lors d'une deuxième étape, la carte de circuit imprimé (15 ; 15a) est mise en liaison fonctionnelle avec les parties de serrage (22), **en ce que**, lors d'une troisième étape, l'autre partie de boîtier (12), de préférence avec interposition d'un autre milieu amortisseur (30), est mise en liaison fonctionnelle avec les parties de retenue (25) de la carte de circuit imprimé (15 ; 15a), de manière à ce que le milieu amortisseur (30) soit réparti entre les parties de serrage (22, 23) et les parties de retenue (25) de la carte de circuit imprimé (15 ; 15a).

8. Procédé selon la revendication 7,
**caractérisé en ce que** le milieu amortisseur (30) est déposé au moins indirectement sur les deux faces de la carte de circuit imprimé (15 ; 15a).

9. Procédé selon la revendication 8,
**caractérisé en ce que** le milieu amortisseur (30) est uniquement déposé sur les parties de serrage (22, 23) de l'une des deux parties de boîtier (11, 12), en particulier, lorsque la carte de circuit imprimé (15) présente des ouvertures de passage (26).
